# EUROPEAN PATENT APPLICATION

(11) **EP 4 734 689 A1**
(43) Date of publication of application: **29.04.2026**
(21) Application number: 25211303.0
(22) Date of filing: 27.10.2025
(51) Int. Cl.: H05K 7/20

(54) **COOLANT DISTRIBUTION UNITS WITH LOCALIZED PROCESSING**

(30) Priority: 25.10.2024 US 202463712173 P
(71) Applicant: Hoffman Enclosures Inc., Anoka, MN 55303 (US)
(72) Inventor: Kundem, Jeshwanth Durga Sagar, Minneapolis (US); Gupta, Abhishek, Maple Grove (US)
(74) Representative: Barker Brettell LLP

(57) **Abstract**

A computer implemented method includes receiving, at a computing system (106), a first real-time input from a cooling system comprising a physical cooling unit providing cooling to liquid coolant within a first range of the computing system. The method includes providing the first real-time input to a machine learning model stored within memory of the computing system, the machine learning model including a model of the physical cooling unit trained to predict behavior of the physical cooling unit. The method includes generating, by the machine learning model, a first output comprising a predicted value of an operational parameter based on the first real-time input. The method includes generating an instruction for operation of the physical cooling unit based on the first output, and communicating the instruction to a controller of the physical cooling unit.

## Description

### CROSS-REFERENCE TO RELATED APPLICATIONS

This application claims the benefit of U.S. Provisional Application No. 63/712,173, filed on October 25, 2024, which is incorporated by reference herein in its entirety.

### BACKGROUND

Cooling systems can be provided for electrical equipment within data centers. Increasingly, data centers can employ a variety of cooling methods tailored to specific workloads and performance requirements. For example, data centers can utilize any or all of air cooling, liquid cooling, multi-phase refrigeration-based cooling, immersion cooling, and the like to cool electrical equipment. Infrastructure and cooling units can be provided to cool electrical equipment, and can include any combination of heat exchangers, fans, liquid pumps, sensors, flow control valves, filtration systems, etc.

### SUMMARY

According to one aspect of the present disclosure, a computer implemented method can include receiving, at a computing system, a first real-time input from a cooling system. The cooling system can include a physical cooling unit to provide cooling to a liquid coolant. The physical cooling unit can be located within a first range of the computing system. The method can include providing the first real-time input to a machine learning model stored within a memory of the computing system. The machine learning model can include a model of the physical cooling unit, and can be trained to predict a behavior of the physical cooling unit. The method can include generating, by the machine learning model, a first output comprising a predicted value of an operational parameter. The first output can be based at least in part on the first real-time input. The method can include generating an instruction for an operation of the physical cooling unit based on the first output. The method can include communicating the instruction to a controller of the physical cooling unit.

In some examples, the physical cooling unit can be one of a liquid-to-air coolant distribution unit (CDU), a liquid-to-liquid CDU, an air-to-liquid cooling unit, a rear-door cooling unit, and an in-rack CDU.

In some examples, the method can further include receiving, from the cooling system, a real-time stream of operational data. The real-time stream can include the first real-time input.

In some examples, the instruction can include a command to change a configuration of the cooling system.

In some examples, the machine learning model can include a plurality of models.

In some examples, the plurality of models can include one or more of a vibration model, a computational fluid dynamics model, and a finite element analysis model.

In some examples, the computing system and the physical cooling unit can communicate using an internet of things (IoT) communication protocol.

In some examples, the machine learning model can be configured to optimize a target parameter of the physical cooling unit based on the first real-time input.

In some examples, the target parameter can be one of an approach temperature, an inlet temperature, a flow rate, and a power usage efficiency.

In some examples, the first range can be a distance allowing for a network latency between the computing system and the physical cooling unit of less than 1 millisecond.

In some examples, the computing system and the physical cooling unit can be located within the same data center.

According to another aspect of the present disclosure, an edge computing system for a coolant distribution unit can include a coolant distribution unit to provide cooling to a liquid coolant. The system can include a computing system located within a first range of coolant distribution unit. The system can include a machine learning model stored within a memory of the computing system. The machine learning model can include a model of the coolant distribution unit, and the machine learning module can be trained to predict a behavior of the coolant distribution unit. The computing system can be configured to receive a first real-time input from the coolant distribution unit. The computing system can be configured to provide the first real-time input to the machine learning model. The computing system can be configured to generate, by the machine learning model, a first output comprising a predicted value of an operational parameter based at least in part on the first real-time input. The computing system can be configured to generate an instruction for an operation of the coolant distribution unit based on the first output. The computing system can be configured to communicate the instruction to a controller of the coolant distribution unit.

In some examples, the coolant distribution unit can be one of a liquid-to-air coolant distribution unit (CDU), a liquid-to-liquid CDU, an air-to-liquid cooling unit, a rear-door cooling unit, and an in-rack CDU.

In some examples, the machine learning model can include a plurality of models comprising one or more of a vibration model, a computational fluid dynamics model, and a finite element analysis model.

In some examples, the machine learning model can be configured to optimize a target parameter of the coolant distribution unit based on the first real-time input.

In some examples, the target parameter can be one of an approach temperature, an inlet temperature, a flow rate, and a power usage efficiency.

According to yet another aspect of the present disclosure, a non-transitory computer-readable medium can store instructions that, when executed by a processor of a computing system, cause the computing system to receive a first real-time input from a cooling system. The cooling system can include a physical cooling unit to provide cooling to a liquid coolant. The physical cooling unit can be located within a first range of the computing system. The instructions can cause the computing system to provide the first real-time input to a machine learning model stored within a memory of the computing system. The machine learning model can include a model of the physical cooling unit and can be trained to predict a behavior of the physical cooling unit. The instructions can cause the computing system to generate, by the machine learning model, a first output comprising a predicted value of an operational parameter based at least in part on the first real-time input. The instructions can cause the computing system to generate an instruction for an operation of the physical cooling unit based on the first output. The instructions can cause the computing system to communicate the instruction to a controller of the physical cooling unit.

In some examples, the coolant distribution unit can be one of a liquid-to-air coolant distribution unit (CDU), a liquid-to-liquid CDU, an air-to-liquid cooling unit, a rear-door cooling unit, and an in-rack CDU.

In some examples, the machine learning model can include a plurality of models comprising one or more of a vibration model, a computational fluid dynamics model, and a finite element analysis model.

In some examples, the machine learning model can be configured to optimize a target parameter of the coolant distribution unit based on the first real-time input, and the target parameter can be one of an approach temperature, an inlet temperature, a flow rate, and a power usage efficiency.

Aspects and embodiments of the invention are defined in the claims. Feature(s) of the aspects/embodiments of the invention or features otherwise disclosed herein may be used separately, together and/or be interchangeable wherever possible. Where features are, for brevity, described in the context of a single embodiment, those features may also be provided separately or in any suitable sub-combination. Features described in connection with the edge computing system or computer readable medium or any feature(s) or component(s) described may have corresponding features definable and/or combinable with respect to a method or vice versa, and these embodiments are specifically envisaged.

### BRIEF DESCRIPTION OF THE DRAWINGS

The accompanying drawings, which are incorporated in and form a part of this specification, illustrate embodiments of the invention and, together with the description, serve to explain the principles of embodiments of the invention:
FIG. 1 is a diagrammatic view of a system for using digital models for cooling equipment within a data center according to aspects of the present disclosure;
FIG. 2 is a diagrammatic view of an example of high-density liquid cooling equipment for use within the data center of FIG. 1;
FIG. 3 is a a diagrammatic view of a piece of cooling equipment for use within the data center of FIG. 1;
FIG. 4 is a diagrammatic view of a controller for computer systems of the data center of FIG. 1;
FIG. 5 is a diagrammatic view of electrical and control aspects of a liquid cooling unit of the data center of FIG. 1;
FIG. 6 is a diagrammatic view of a system for using digital twins for cooling equipment within the data center of FIG. 1; and
FIG. 7 is a flowchart showing a process for deploying a digital twin for cooling equipment of the data center of FIG. 1.

### DETAILED DESCRIPTION

The following discussion is presented to enable a person skilled in the art to make and use embodiments of the invention. Various modifications to the illustrated embodiments will be readily apparent to those skilled in the art, and the generic principles herein can be applied to other embodiments and applications without departing from embodiments of the invention. Thus, embodiments of the invention are not intended to be limited to embodiments shown but are to be accorded the widest scope consistent with the principles and features disclosed herein. The following detailed description is to be read with reference to the figures, in which like elements in different figures have like reference numerals. The figures, which are not necessarily to scale, depict selected embodiments and are not intended to limit the scope of embodiments of the invention. Skilled artisans will recognize the examples provided herein have many useful alternatives and fall within the scope of embodiments of the invention.

When electrical equipment (e.g., servers, network equipment, batteries, storage nodes and disks, etc.) is operated, the equipment can generate excess heat (e.g., waste heat). Overheating of electrical equipment can result in degradation of components of the electrical equipment, and in some cases, can cause damage or reduce a lifespan of the electrical equipment. Cooling systems can therefore be provided for electrical equipment to maintain the electrical equipment at safe temperature ranges (e.g., at a temperature or within a temperature range that prevents heat-induce damage to the electrical equipment). As a specific example, in a data center context, electrical equipment can include servers, which can generate a heat when performing computing workloads. Servers, and other computing equipment (e.g., power supply and power storage components, network switches and routers, storage drives, storage disks, etc.) can be provided in high-density arrangements within a data center, as can maximize a computing capacity within a space constraint of the data center. The servers and other computing equipment can be arranged within racks of the data center (e.g., in a stacked arrangement), which, in turn, can be arranged in rows within the data center.

Cooling systems can be provided for electrical equipment within a data center, to prevent an over-heating of the electrical equipment. In some cases, equipment within a data center can be cooled using air cooling (e.g., by providing a flow of cool air across electrical equipment and removing heated air from the data center). Increasingly, advances in computing technology allow for greater computing capacity (e.g., higher-powered central processing units (CPU), graphics processing units (GPU), or other computing chips) within a given volume (e.g., a server chassis). In some cases, a cooling capacity or density (e.g., amount of cooling per a given footprint in a data center) can be increased through the use of liquid-based or hybrid cooling systems. For example, servers and other cooling equipment can be cooled via a liquid cooling (e.g., via a direct-to-chip liquid cooling system), immersion cooling, multi-phase refrigeration cycles, air-to-liquid cooling, liquid-to-air cooling, etc.

Cooling infrastructure can be provided to implement cooling of computing equipment. For example, coolant distribution units (CDUs) can include any or all of heat exchangers, air flow components (e.g., fan assemblies), fluid flow components (e.g., pumps, valves, etc.), sensors (e.g., temperature sensors, pressure sensors, flow sensors, humidity sensors, Hall sensors, etc.). CDUs can be provided in dedicated racks (e.g., "in-row CDUs") or can be mountable within a rack of electrical equipment (e.g., "in-rack CDUs"). Further, CDUs can be provided for liquid-to-liquid heat exchange, liquid-to-air heat exchange, refrigeration-based heat exchange, immersion cooling, etc. In some cases, cooling systems can include alternative or additional component to CDUs, including, for example, air-to-liquid cooling unit (e.g., for transferring heat from a heated air to a chilled fluid from a facility supply), pumping units, filtration and fluid processing units (e.g., racks of filtration elements), rear-door cooling units, etc. It can be advantageous to provide digital twins for cooling infrastructure (e.g., any of, or any combination of in-row CDUs, in-rack CDUs, chilling units, pumping units, liquid-to-air cooling units, a rear-door cooling unit), as can reduce a management overhead for cooling infrastructure, provide for predictive modeling, allow for assessment of the equipment under various operating conditions, enhance a monitoring of the cooling infrastructure, allow for development of tailored models for given environments, etc.

Some examples of the discussion below describe digital modeling of physical cooling infrastructure within a data center. In some examples, digital models for cooling infrastructure can comprise one or more machine learning model that can be trained to simulate a behavior of the cooling infrastructure. Digital models can correspond to individual cooling units within a data center (e.g., coolant distribution units (CDUs), rear-door cooling units, chillers, pumping units, etc.). In some cases, digital models for cooling infrastructure can include multiple models corresponding to individual cooling units within a data center. For example, a liquid cooling circuit can include a liquid-to-air CDU and a plurality of rear-door cooling units, and a model for the liquid cooling circuit can include a model for the liquid-to-air CDU, and models for the rear-door cooling units. In some cases, digital models for cooling units can be referred to as a "digital twin." As used herein, a "digital twin" means a software representation of a physical item (e.g., coolant distribution units, pumps, heat exchangers, rear-door cooling units, etc.).

A digital model can be configured to mimic an aspect of the corresponding physical item. For example, a digital model can include a structural model of a CDU and can provide a simulation of stresses on the mechanical components of the CDU under different load conditions. As discussed further below, a digital model, according to examples of the disclosure can also include models for other aspects of an item, including fluid flow models, thermal models, electrical models, vibration models, etc. In some cases, digital models can be trained artificial intelligence models that can be trained to simulate a behavior of components or systems of a CDU. Embodiments of the disclosed systems and methods can be used in other contexts, such as for cooling equipment other than servers, or various other electronics, configured in various ways, including with other shapes and arrangements of elements. While the discussion below is provided in the context of a data center, the disclosed systems and method can be used for cooling outside of a data center.

As described below, models for cooling infrastructure (e.g., individual cooling units, or combinations of cooling units) can be complex and, in some cases, can include multiple sub-models. Training and developing complex models (e.g., the models described herein) can require large volumes of data, and training a model can be compute-intensive. In some cases, server farms including specialized computing chips (e.g., central processing units (CPUs), graphics processing units (GPUs), application-specific integrated circuits (ASICs), etc.). Training and developing a model for cooling infrastructure can further require hours or days to perform. In some cases, it can be advantageous to develop, train, and refine models using a first computing system (e.g., a server farm configured for performing machine learning operations), and to deploy trained models to data centers to be co-located with corresponding equipment. For example, a model can be a model trained to detect anomalies in data from a cooling unit (e.g., anomalies in a detected temperature, pressure, flow rate, etc.) in real-time and provide alerting to an operator based on the detected anomaly.

In some cases, a model can be integrated into control systems of a cooling unit, and the cooling unit can be controlled at least partially based on an output from a model, as further described below. In these and other applications, a network latency can make it impractical for data to be sent off-site (e.g., outside of a data center or data center complex) to be processed at another location. Co-locating models with the corresponding cooling infrastructure (e.g., CDUs, pumping units, chillers, rear-door cooling units, etc.) can allow for real-time processing of data (e.g., valve positions, pump speeds, fan speeds, temperature values, humidity values, pressure values, etc.) and can allow models to be used in controlling, alerting, and monitoring of the cooling units in real-time, or in near real-time. In some examples of the present disclosure, edge computing capability can be provided for cooling units to allow for processing of data from the units and use of models (e.g., machine learning models) to facilitate an operation of the cooling units.

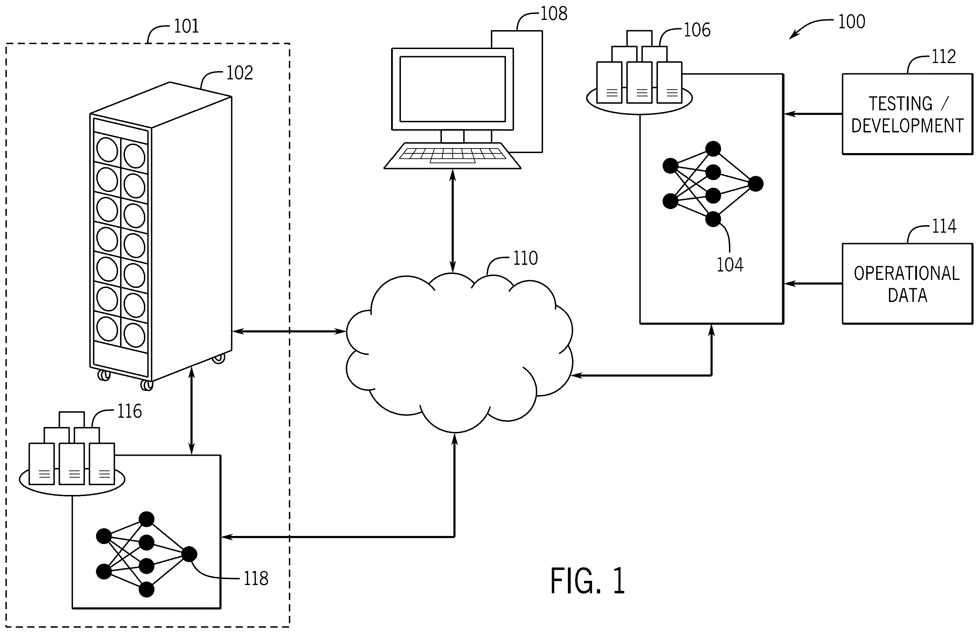

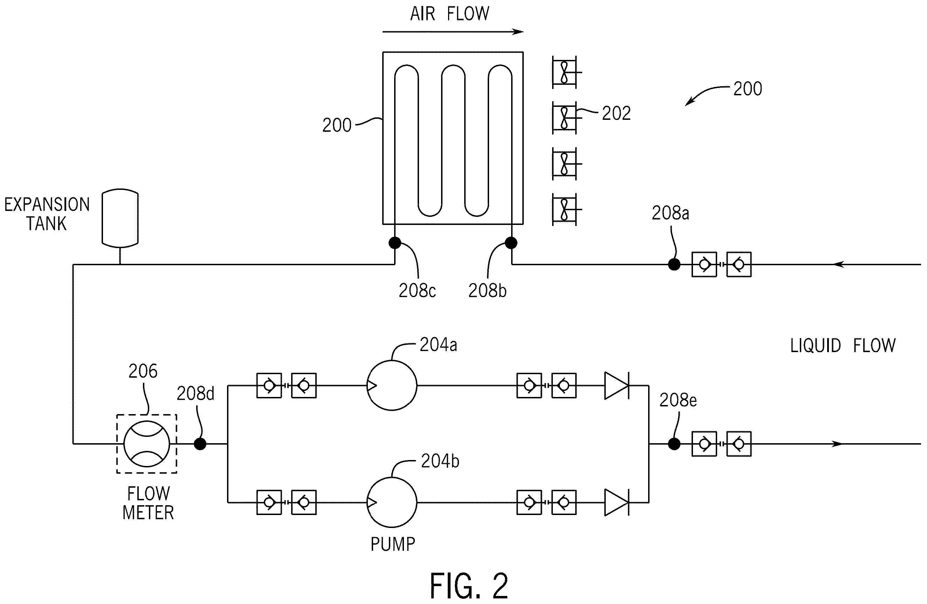

FIG. 1 illustrates an example schematic of a system 100 for using edge computing for cooling infrastructure. As shown, the system can include a data center 101, which can house electrical equipment requiring cooling (e.g., servers, network equipment, power supply components, etc.). A cooling unit 102 can be provided in the data center 101 to provide cooling for the electrical equipment within the data center 101. In the illustrated example, the cooling unit 102 is an in-row liquid-to-air CDU, configured to provide a flow of coolant to electrical equipment to be cooled. For example, as discussed further with respect to FIG. 2, the cooling unit 102 can include a rack that can have housed therein a liquid-to-air heat exchanger (LTA HX). Pumps of the cooling unit 102 can pump a liquid coolant through the LTA HX, and through a liquid cooling circuit including electrical equipment to be cooled. The cooling unit 102 shown further includes fans to provide a flow or air across the LTA HX to affect a desired cooling of the liquid coolant flowing through the LTA HX. While the cooling unit 102 described herein is an in-row LTA CDU, the discussion of the present disclosure is equally applicable to other cooling infrastructure. For example, edge computing systems for data center cooling can include an in-row liquid-to-liquid (LTL) CDU, an in-rack LTA CDU, chillers, rear-door cooling units, replaceable pumping units (RPUs), etc.

In some cases, edge computing systems, according the present disclosure can include models for a cooling system including multiple cooling units, including, for example, various types of cooling units. For example, a primary cooling circuit can include a liquid-to-liquid CDU, a liquid-to-air CDU (e.g., the LTA CDU 102) and multiple rear-door coolers, and the model can include sub-models corresponding to each of the component cooling units of the cooling system.

As further shown, the system can include a computing system 106, which can be a computing system for developing and training machine learning models. In some cases, the computing system 106 can comprise a plurality of physical or virtual computing resources (e.g., servers, containers and containerized applications, server clusters, etc.). In some embodiments, machine learning models for cooling infrastructure may be trained and constructed by one or more ASICs. ASICs may be specially customized for a specific machine learning application and provide superior computing capabilities and reduced electricity consumption compared to traditional CPUs.

Training and developing digital models for cooling systems can require significant computing resources. In some cases, the computing resources required for developing and training a model can exceed a capacity of computing resource that are collocated with a cooling system. Thus, as shown in FIG. 1, a model 104 can be developed and trained at a first computing system (e.g., computing system 106 shown in FIG. 1), and, once trained, can be deployed to locations where the model can be integrated with real-time operational data of a cooling system (e.g., the model 118 can be collocated with the LTA CDU 102). In this regard, the computing system 106 can have stored thereon a digital model 104.

In the illustrated example, the digital model 104 can be a model that is constructed and trained to mimic or predict a behavior of the cooling unit 102. In some cases, the digital model 104 can be trained to optimize a parameter (e.g., a cooling capacity, a power consumption, an efficiency, etc.) based on received inputs corresponding to operating parameters of the cooling unit (e.g., sensed temperature, pressure, flow rate, and humidity values, pump speed values, valve positions, fan speed, etc.). In some cases, the model 104 can provide maintenance recommendations based on received operating parameters. In some cases, the model 104 can detect anomalies in values and provide alerting or recommendations for mitigation of irregularities causing the anomalies.

As shown, the computing system 106 can receive testing and development input 112. Testing and development inputs can include three-dimensional models of the cooling unit, specifications for elements of the cooling unit (e.g., pump specifications, fan specifications, rated efficiencies for heat exchangers, etc.), information about materials of the cooling unit, information about connections (e.g., welds, bolted or screwed connections, sliding interfaces, etc.) etc. In some cases, the testing and development information 112 can be used as a foundation for one or more machine learning models, to which additional layers can be added (e.g., convolutional layers). For example, known geometries from the testing/development data, materials, and pump and fan specifications can be used to model a fluid flow through the cooling unit given differing inputs, and this fluid flow model can be adjusted or fine-tuned based on empirical data.

Further, the computing system 106 can access operational data 114 (e.g., empirical data). The operational data 114 can include a data store (e.g., a database, an object storage system, log entries, etc.) including data obtained from operation of cooling units that are similar or identical to the cooling unit 102. In some cases, the operational data can be used to develop or fine-tune models (e.g., supervised and unsupervised models) for the cooling unit (e.g., model 104). In some cases, the computing system 106 can continually receive one or more feeds of operational data 114, and can continually develop, test, and validate the model based on the operational data 114. Operational data can comprise sensor readings (e.g., readings of temperature sensors, pressure sensors, flow rate sensors, etc.), unit configuration values (e.g., operating modes for the cooling units from which the data is sourced, gains of PID controllers, etc.), historical data for speeds of pumps and fans, valve positions, alerts and error messages, etc.

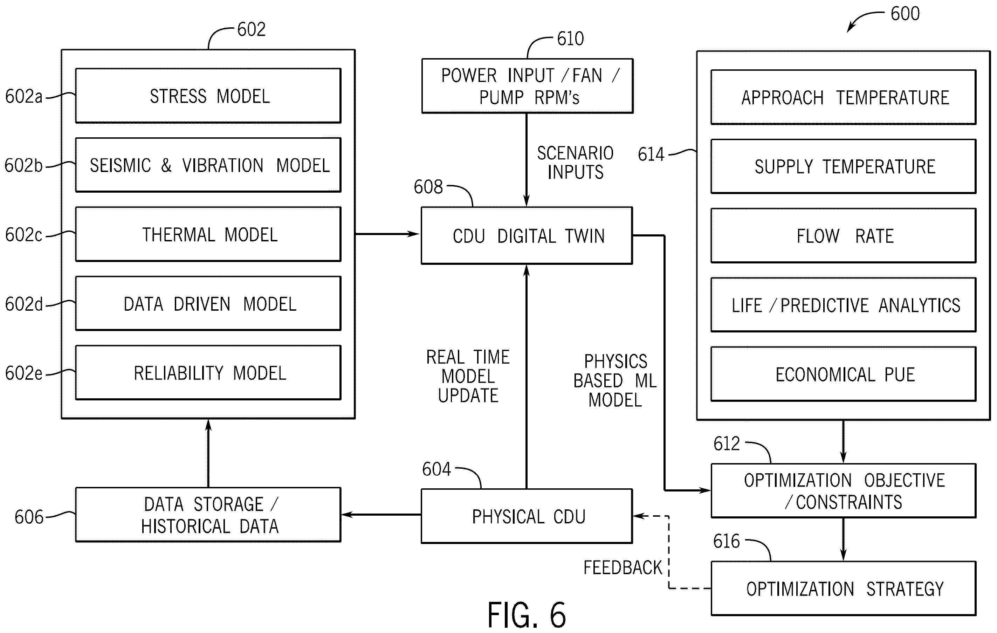

The model 104 can comprise software libraries and modules that can be organized (e.g., packaged) as a downloadable executable or software package. For example, the model 104 can be packaged as an executable file (e.g., one or more files with an .exe, .bat, .com, .cmd, .inf, .ipa, .osx, .pif, .run, .wsh extensions, or other know file formats). In some cases, a model can be packaged in one or more containerized applications. In some cases, a model can be modular, and components of the model can be independently installed or upgraded on a destination computer system (e.g., a computer system at which the model is installed). For example, the model can be a composite model including thermal models, structural models, stress models, data driven models etc. (e.g., as shown in FIG. 6) and individual component models of the composite model can be packed individually, as can allow them to be used or upgraded independently of the composite model.

In some cases, the model can be integrated as a library or package that is compatible with other software packages or coding languages. For example, the model 104 can be packaged as a Python library that can be downloaded and referenced within Python scripts or Python-based applications. In some cases, libraries comprising the model can be provided in any known coding language. In some cases, the computer system 106 can provide an interface (e.g., a web interface, an application programming interface (API), a command line interface (CLI) a file system interface, etc.) at which software packages for the model 104 can be downloaded.

In some cases, a model can comprise a digital representation of a physical unit that can model a behavior of the physical unit. In some cases, a model for a cooling unit (e.g., a "digital twin") can comprise one or more artificial intelligence models that can be developed based on design characteristics of the physical unit, and can be trained on training data to ensure that a simulated behavior of the model is similar or identical to a behavior of the physical unit. Referring back to FIG. 1, in the illustrated example, the model 104 is a digital models of an in-row LTA CDU, having similar characteristics (e.g., identical characteristics) as the LTA CDU 102. The model 104 can comprise multiple sub-models each simulating aspects of the LTA CDU 102. For example, the models 104 can include a mechanical model of the LTA CDU 102 including defined dimensions of the frame, materials of the CDU 102, connection points, etc. The mechanical model included in the model 104 can allow a modeling of a mechanical behavior of the CDU 102 based on known physics of the materials and structure of the CDU 102 (e.g., the digital twin can include physics-based models that can operate based on a digital definition of the CDU 102).

A physics-based model of a CDU 102 can be based on a three-dimensional computer-aided design (CAD) model of the CDU 102 in which materials, a structure, and connection interfaces (e.g., welds, fasteners, interlocking components, fluid connections) are defined. In some cases, as described below, an operator of a CDU (e.g., the CDU 102) can use a physics-based model to predict a mechanical behavior of the CDU, predict failure of components, plan maintenance activities, model prospective scenarios based on various potential operating conditions, etc.

As further shown in FIG. 1, the system 100 can include an on-site computing system 116. The on-site computing system can comprise one or more computers, servers, virtual servers, or other computing devices capable of storing and executing software. In some cases, the computing system 116 is hosted at a controller of the cooling unit 102, or on a computing device housed at the cooling unit 102 (e.g., a microprocessor). In some cases, a controller of the cooling unit 102 can be a component computing device of the computing system 116. As shown, the computing system 116 can be co-located with the cooling system 102. For example, the computing system 116 can be located in the same data center 101 with the cooling unit 102, or in the same data center complex (e.g., in a data center on a campus with the data center 101 hosting the cooling unit 102). In some cases, a computing system can be considered "co-located" with a cooling unit according to the present disclosure if the computing system is within one mile of the cooling unit, or within five miles, or within ten miles. In some cases, a computing system can be considered co-located with a cooling unit if a latency (e.g., a network latency of a local area network (LAN), a wired connection, a wide area network, etc.) is less than 1 ms, or less than 5 ms.

In the illustrated example, the computing system 116 is within the same data center 101 as the cooling unit 102, and is in communication with a control system of the cooling unit 102. A network latency between the cooling unit 102 and the computing system 116 can be less than 1 ms. In some cases, the computing system 116 and the cooling unit 102 are connected over a LAN. In some cases, the computing system 116 can be connected to the cooling unit through any or multiple of a Bluetooth connection, a serial connection, a universal serial bus (USB) connection, a Universal Asynchronous Receiver-Transmitter UART connection, an ethernet connection, or a proprietary connection type leveraging proprietary protocols. In some cases, the computing system 116 can be portable (e.g., housed on a tablet or laptop computer). The computing system 116 can be an "edge computing" device capable of performing computationally intensive engineering calculations (e.g., running simulations of a model, providing output from a model based on inputs received from the cooling unit, etc.). In some cases, the computing system 116 can be in communication with multiple cooling units.

In some examples, cooling units can be configured to broadcast sensor readings and be integrated into an internet of things (IoT) infrastructure within the data center, and the computing system 116 can consume information generated by cooling units broadcast in the same network. The cooling unit 102 and the computing system 116 can be connected through a network connection designed for low-power IoT applications utilizing short-lived connections. An IoT network connection can utilize technologies such as machine-to-machine (M2M) or machine-type communications (MTC) for exchanging data with an MTC server or device via a public land mobile network (PLMN), Proximity-Based Service (ProSe) or device-to-device (D2D) communication, sensor networks, or IoT networks. In at least one embodiment, a M2M or MTC exchange of data may be a machine-initiated exchange of data. In some examples, an IoT network describes interconnecting IoT devices, which may include uniquely identifiable embedded computing devices with short-lived connections. In some examples, an IoT device (e.g., the computing system 116, the CDU 102, etc.) may execute background applications (e.g., keep alive messages, status updates, etc.) to facilitate connections of an IoT network.

Edge computing devices or systems (e.g., computer system 116) can have stored thereon software capable of performing engineering simulations to simulate a behavior of one or more cooling systems (e.g., cooling unit 102). In some cases, an edge computing device can have stored thereon one or more models for generating a simulated (e.g., predictive) output based on real-time data received from a cooling unit. A model stored on an edge computing device can be an engineering model (e.g., a model based on a three-dimensional CAD model, known materials and specifications for the cooling unit, etc.). In some cases, a model hosted on an edge computing device can be a trained machine learning model. In some cases, a model hosted on an edge computing device can be a combination of an engineering model and a trained machine learning model.

As shown in FIG. 1, the computing system 116 can have stored thereon a model 118. The model 118 can be a model for simulating one or more behaviors of the cooling unit 102. For example, the model 118 can receive real-time inputs (e.g., a real-time stream of sensor data from temperature sensors, flow rate sensors, pressure sensors, humidity sensors, etc.) from the cooling unit in real-time, and can generate outputs which can simulate or predict a behavior of the cooling unit. In some cases, the model 118 can generate recommendations for operation of the cooling unit. For example, the model can determine optimal configuration settings, operating modes, pump speeds, fan speeds, etc. to achieve an optimal power efficiency, optimal thermal performance, optimal uptime, etc. In some cases, the recommendations can be provided to an operator, including, for example, at a display of the computing system (e.g., a touchscreen panel mounted at a door of the cooling unit 102). In some cases, the model 118 can autonomously implement generated recommendations by controlling configurations and system inputs (e.g., pump speeds, fan speeds, valve positions, etc.) to achieve the desired optimization or other target behavior. In some cases, computing systems can include models for multiple cooling units, or for combinations of cooling units, and can select a model based on a known parameter of a cooling unit. For example, a cooling unit can communicate identifying information to the computing system including an ID or model type of the cooling unit, and the computing system can perform a lookup using the identifying information to select a model for processing input information from the cooling unit.

As shown further shown in FIG. 1, both of the cooling unit (e.g., a control system of the cooling unit 102) and the computing system 116 can be communication with the computing system 106 through a communications network 110. In some embodiments, the communications network 110 can include any suitable hardware, firmware, or software for communicating information digitally between computing systems 116, 106 and a control system of the CDU 102. For example, the communications network can include hardware, firmware or software that can be used to establish a Wi-Fi connection, a Bluetooth connection, a cellular connection, an Ethernet connection, etc. In some cases, a latency of a connection through the communications network can be greater than a latency of the connection between the computing system 116 and the cooling unit 102.

As noted above, in some cases, a model for a cooling system (e.g., the CDU 102) can be developed and trained on first computing system (e.g., computing system 106), and once developed, can be deployed to a location collocated with the cooling system (e.g., computing system 116). For example, a latency in a network connection above a threshold (e.g., greater than or equal to 5 milliseconds (ms), 10 ms, 15 ms, 20 ms, 30 ms, or greater than 30 ms) between a model (e.g., the model 104) and a cooling unit corresponding to the model (e.g., the CDU 102) can render real-time use of the model (e.g., for monitoring, controlling an operation of the cooling unit, providing real-time alerting or optimization, etc.) impractical or impossible. As similar (e.g., identical) cooling systems (e.g., CDUs) can be deployed in multiple geographies by multiple entities, it can further be beneficial to provide a centralized system for obtaining a model for the cooling system from which the model can be downloaded for use at a control system of the cooling system, or co-located with the cooling system.

Referring still to FIG. 1, the computing system 116 can obtain (e.g., download) the model 118 from the computing system 106 via the network connection 110. The model 118 can be a localized instance of the model 104. In some cases, the model 104 can be selected from a plurality of models available at the computing system 106. For example, the computing system 106 can include a model of an LTA CDU for operations under a first set of conditions (e.g., an ambient temperature range, a type of coolant used, whether the LTA CDU is used for immersion cooling or direct-to-chip cooling, etc.) and another model for an LTA CDU operated under a second set of conditions, and an operator can select the model adapted for the operating conditions that most closely resembles the operating conditions of the data center in which a corresponding LTA CDU is installed.

In some cases, it can be useful to update a model. For example, software libraries used in the model can require patching and updating. Additionally, a model at a centralized computing system (e.g., the computing system 106) can be fine-tuned using operational data (e.g., operational data 114 obtained from cooling systems in operation), and updates can be made to the model to improve the model's performance. Further, versions of a model can be developed for particular use cases. For example, a first version of a model for an LTA CDU can model a behavior of the LTA CDU when water is used as a coolant, and a second version of the model for the LTA CDU can model a behavior of the LTA CDU when a water-glycol mixture is used as a liquid coolant. An operator can periodically (e.g., according to a schedule, upon availability of an updated model, etc.) perform an update of the model 118 to align with updates made to the model 104. In some cases, a central computing system (e.g., computing system 106) can have downloadable models for multiple different cooling units (e.g., LTA CDUs, LTL CDUs, rear-door cooling units, in-rack CDUs, air-to-liquid cooling units, RPUs, etc.) and an operator can download the models corresponding to each cooling unit included in a cooling system. Updates to a model (e.g., to the model 118) can be made by an operator, or can be automated to occur when updates are available.

As shown, the system 100 can further include a computing system 108. The computing system 108 can be a personal computer, a table, a mobile phone, a virtual computer (e.g., a software-defined device), etc. The computing system 108 can be a device through which a user can communicate with one or all of the LTA CDU 102 (e.g., or other cooling infrastructure), the computing system 116, and the computing system 106. For example, either or both of the LTA CDU 102 and the computing system 116 can provide an interface through which to read data from or provide commands to the CDU 102. In some cases, an interface of one or both of the CDU 102, the computing system 116, and the computing system 106 can include a web interface, an application programing interface (API), a command line interface (CLI) or any other interface as can allow a computing system110 to communicate with cooling infrastructure or software and infrastructure hosting digital twins of the cooling infrastructure.

FIGS. 2, 3, and 4 provide illustrations of particular cooling systems and components of cooling systems for which models can be provided, as described in FIG. 1. The examples of FIGS. 2, 3, and 4 are provided for illustrated, and are not intended to be limiting. For example, while the illustrated examples show various aspects of an LTA CDU, the present disclosure is equally applicable for other cooling systems including, for example, for LTL CDUs, immersion cooling systems, rear-door cooling units, RPUs, ATL cooling units, air cooling units, filtration units, and any combination thereof. FIG. 2 illustrates a schematic showing elements of a CDU 200 along a flow path of liquid coolant. The CDU 200 can be similar or identical to the LTA CDU 102. As shown, the CDU 200 includes a liquid-to-air heat exchanger 201 (LTA HX), fans 202, a flow meter 206 (e.g., a sensor for sensing a fluid flow rate through the CDU 102), and redundant pumps 204a, 204b. A liquid coolant can flow from an inlet through the LTA HX 201 and can continue to flow through the flow meter 206, and can be pumped to downstream equipment through one or both of the pumps 204a, 204b. The fans 202 can produce an air flow across the LTA HX 201 to increase a transfer of heat from the liquid coolant to the air at the LTA HX 201. Further, sensor modules 208 can be provided along the flow path of fluid through the CDU 200 (e.g., one or both of a flow path of liquid coolant and air). The sensor modules 208 can include one or both of a temperature sensor and a pressure sensor for the liquid coolant flowing through the CDU 200.

In the illustrated example, the sensor modules 208 include an inlet sensor module 208a, an outlet sensor module 208e, a sensor module 208b immediately upstream of the LTA HX 201, a sensor module 208c immediately downstream of the LTA HX 201, and a sensor module 208d immediately upstream of the pumps 204a, 204b. In other examples, a cooling unit can include more or fewer sensor modules, and sensor modules can be differently arranged along a fluid flow path. Measured values from the sensor modules 208 can be used to implement control procedures for the CDU 200. For example, PID controllers implemented by a control system of the CDU 200 can be configured to control an operation of the pumps 204a, 204b and the fans 202 to achieve a desired outlet temperature at any of module 208c, 208d, 208e. In some cases, sensors and sensor modules can provide redundancy and failover capacity in the event of a failure of another sensor module. The sensor modules 208 can continually gather measurements, and those measurements can be monitored and analyzed, as described below, to perform diagnostics and troubleshooting, optimize a performance of the CDU, and provide predictive capabilities for the CDU 200.

In some cases, sensors can be provided at the fans 202 (e.g., humidity sensors, temperature sensors, flow rate sensors, pressure sensors, etc.) and measurements obtained from the sensors can further be used to operate the CDU 200 (e.g., to implement PID controls, generate alerts, provide historical data, etc.). While FIG. 2 illustrates aspects of the LTA CDU 200, the teaching of this disclosure is equally applicable for other cooling infrastructure including, for example, liquid-to-liquid CDUs, chillers, rear-door cooling units, RPUs, etc., and the example provided is given for purposes of illustration.

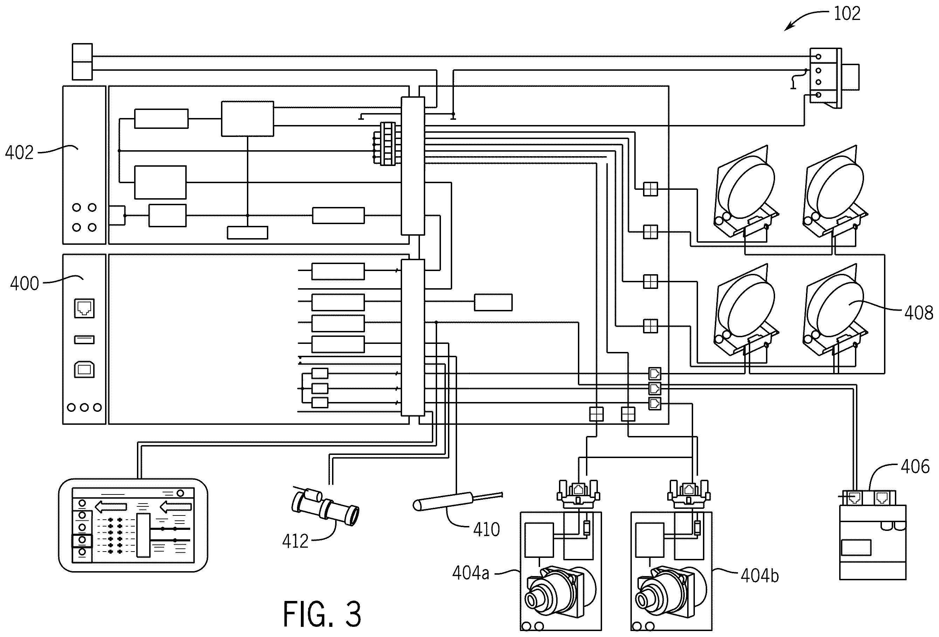

Cooling infrastructure within a data center (e.g., the CDU 102 within the data center 101) can further include electrical and control systems for operating the respective infrastructure. With continued reference to the LTA CDU 200, FIG. 3 illustrates an electrical and controls diagram illustrating a communication between elements of the LTA CDU 200. As shown, the LTA CDU 200 includes a controller 400. As further shown, the LTA CDU 200 can include a power board 402, pumps 404a, 404b (e.g., the control aspects for the pumps 204a, 204b shown in FIG 2), fans 408, a leak detection system 406, sensors 410, and a flow sensor 412. As shown, each of the electrical components of the LTA CDU 200 is in communication with the controller 400. For example, the sensors 410, 412 can provide measurement values to the controller 400, and the controller 400 can issue command signals to the pumps 404a, 404b and the fans 408 to increase a speed, decrease a speed, change an operating mode, etc. In some cases, the controller 400 can provide an interface (e.g., through a wired or wireless connection) to allow an operator to view operational parameters of the LTA CDU 200 and to control an operation thereof.

In some examples, electrical systems of an LTA CDU can include additional elements controllable by a controller. For example, a fill pump can be provided to inject a fluid into a liquid cooling circuit upon a determination that a pressure is reduced within the circuit. In some cases, power supply units can be operated in various modes in response to communications from a controller. In some cases, a cooling unit can operate in an autonomous mode when a controller is removed (e.g., local controllers for any or all of pumps 404a, 404b and fans 408 can operate the respective elements 404a, 404b, 408 according to predefined behaviors when a communication with the controller 400 is interrupted or lost).

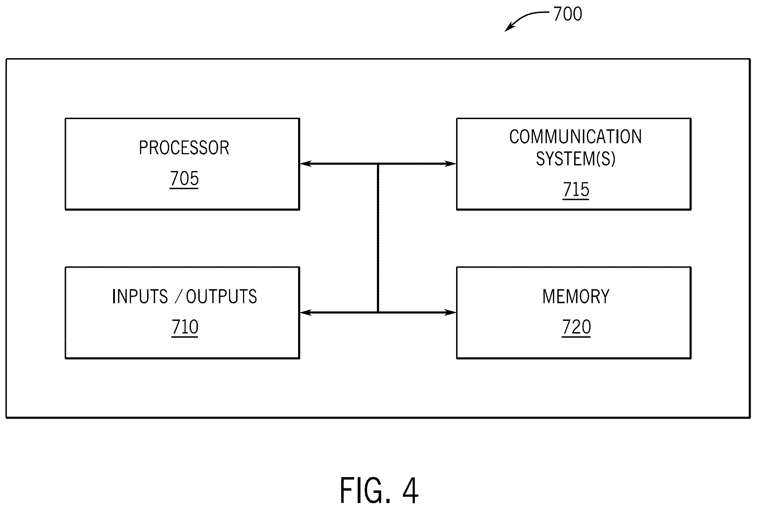

FIG. 4 illustrates an example controller 700, of which the controller 400, all or a portion of the computing system 106, or all or a portion of the computing system 116 can be an instance or a variant. In some embodiments, the controller 700 can be a programmable logic controller (PLC). In some embodiments, the controller 700 can include a Processor 705, one or more Input/Output interfaces 710, a Communication System(s) 715, and a Memory 720. In some embodiments, the Processor can be any suitable hardware processor or combination of processors, such as a central processing unit (CPU), a graphics processing unit (GPU), an application specific integrated circuit (ASIC), a field-programmable gate array (FPGA), etc. In some embodiments, one or more Input/Output interfaces can include any suitable display device, such as a computer monitor, a touchscreen, a television, any suitable input devices or sensors that can be used to receive user input, such as a keyboard, a mouse, a touchscreen, a microphone, a camera, etc. In some cases, inputs can be received at a display which can present a user interface through which an operator can view system parameters, and set control parameters (e.g., set an operating mode, define set points for temperature or pressure, set a language of the system, etc.). In some cases, an Input/Output interface can be an API, a CLI, a wired interface, etc.

In some embodiments, the Communication System(s) 715 of the controller 700 can include any suitable hardware, firmware, or software for communicating information over any suitable communication networks. For example, the Communication System(s) 715 can include one or more transceivers, one or more communication chips and/or chip sets, etc. In a more particular example, the Communications System(s) can include hardware, firmware and/or software that can be used to establish a Wi-Fi connection, a Bluetooth connection, a cellular connection, an Ethernet connection, etc. In some embodiments, inputs can be received at the controller 500 through the Communication System(s) (e.g., over a communication network). For example, the controller 400 can be a controller of a cooling unit (e.g., controller 400 shown in FIG. 3) an application programming interface, command line interface, or web interface can be provided for a liquid-to-air cooling unit to allow an operator to control the liquid-to-air cooling unit remotely.

In some embodiments, the Memory can include any suitable storage device or devices that can be used to store instructions, values, etc., that can be used, for example, by the Processor of the controller 500 to implement control loops and algorithms, to store logs of the controller 500, etc. The Memory can include any suitable volatile memory, non-volatile memory, storage, or any suitable combination thereof. For example, the Memory can include random access memory (RAM), read-only memory (ROM), electronically-erasable programmable read-only memory (EEPROM), one or more flash drives, one or more hard disks, one or more solid state drives, one or more optical drives, etc. In some embodiments, the Memory can have encoded thereon a computer program for controlling operation of the Controller 500.

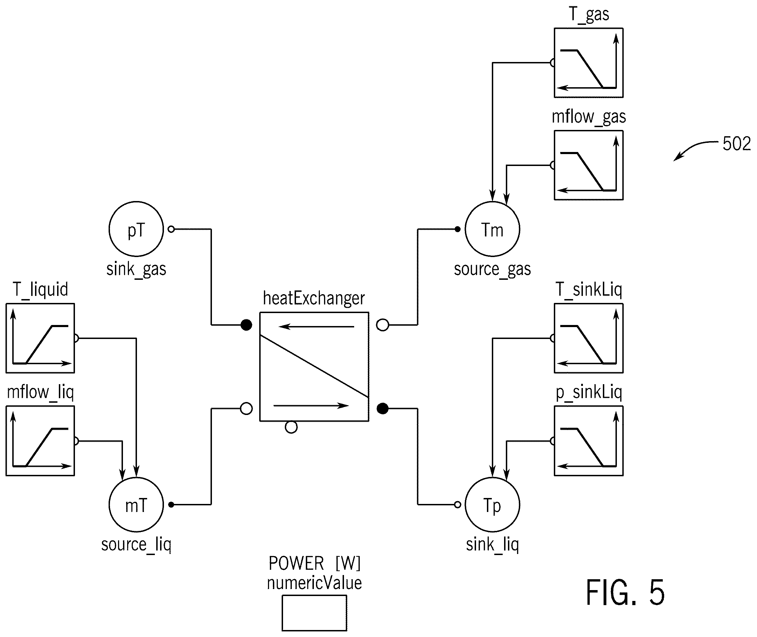

In an example, a physics-based model can be provided to model a heat transfer at one or more points along a cooling system (e.g., a cooling system including the LTA CDU 102, LTA CDU 200, etc.). For example, FIG. 5 illustrates a model 502 for a heat exchanger (e.g., the LTA HX 201 shown in FIG. 2), which, as mentioned, can be a physics-based model (e.g., can model a behavior of the heat exchanger based on known physical characteristics, materials, and configuration of the heat exchanger according to physics-based rules). In the illustrated example, the heat exchanger model simulates an LTA HX, with a liquid coolant flowing through the LTA HX and transferring a heat to a gas (e.g., air) flowing across the LTA HX. As shown, inputs can be defined for any or all of a fluid inlet (mT), a fluid outlet (Tp), an air inlet (pT), and an air outlet (Tm). For example, in the example shown, an input at the fluid inlet can include a mass flow of fluid over time and an inlet temperature of the fluid over time. In some cases, inputs can comprise schedules for operating parameters that can be based on known usage parameters and peak usage times for the cooling units. Additional inputs shown are a pressure of a fluid at the fluid outlet over time, a temperature of the fluid at a fluid outlet over time, a temperature of a gas at the air inlet over time, and a mass flow rate of the gas at the air inlet over time. The model can calculate parameters of the gas at the air outlet based on the inputs received. The model can also calculate a heat transfer rate based on known configuration of the LTA HX and the inputs. In some cases, more or fewer inputs can be provided. The example provided is not intended to be limited, but is an example of a model of a component of a cooling unit (e.g., the CDU 102) that can be included in a digital model. In some cases, a digital model can include sub-models for additional components. For example, the models 104, 118 shown in FIG. 1 can include mechanical, electrical, and flow models for the pumps 204a, 204b, the fans 202 shown in FIG. 2, plumbing arrangements of the CDU 200, etc.

In some cases, a digital model for a cooling system (e.g., a cooling system including the LTA CDU 102 shown in FIG. 1) can comprise one or more trained artificial intelligence models. For example, a model can be trained on operational data (e.g., operational data 114 shown in FIG. 1 including historical measurements received from sensors of a CDU, such as sensor modules 208, flow sensor 206 shown in FIG. 2, etc.). An artificial intelligence model can be data driven and can provide predictive capabilities based on a volume of training data. In some cases, an artificial intelligence model can supplement or augment physics based models. For example, a physics-based model can differ from a physical product due to variations in tolerances, or other variations of a CDU from the defined parameters of the physics-based model. In some cases, a performance of a CDU can be compared to a predicted performance from a physics-based model and when a performance differs from the physics-based model, the physics-based model can be tuned to accurately model the CDU (e.g., through a machine-learning training process). In some cases, a digital model can comprise a trained artificial intelligence model configured to provide predictions of an output (e.g., a mechanical output, a component behavior, an electrical configuration, etc.) for the system based on input parameters. For example, the model 118 can receive as input an ambient air temperature and a return temperature of a liquid coolant, and can generate an operational configuration (e.g., a fan speed, pump speed, defined PID control gains, etc.) to meet desired performance characteristics (e.g., a temperature differential, a pressure differential, a flow rate, etc.) given operational constraints (e.g., maximum and minimum values for any of temperature, pressure, flow rate, etc.).

In some cases, a digital model can control an operation of a corresponding physical product. For example, as noted above, the CDU 102 can provide real-time operational data to the computing system 116 as input to the model 118, and based on an output of the 118, the computing system 106 can provide a signal to the CDU 102 to control an operation of the CDU 102. In an example, the model 118 can predict a failure of a pump (e.g., one of the pumps 204a, 204b shown in FIG. 2) based on operational data received from the CDU 102, and can issue a command to the CDU 102 to initiate a failover process for the pumps. In some cases, as noted above, the digital model 118 can generate an optimal configuration for the CDU 102 (e.g., an optimal operating mode, PID control parameters and speed for the pumps and fans, maximum and minimum threshold values for speeds of the pumps and fans and temperatures of the air and fluid coolant, etc.), and can issue a command to the CDU 102 to change the configuration to the generated optimal configuration. In some cases, the computing system 116 can issue an approval request to the computing system 108 before implementing a change at the CDU 102, and can implement the change upon a received approval at the computing system 108 from an operator.

FIG. 6 illustrates another example system 600 for using models to enhance an operation of a data center cooling unit. As shown, a plurality of models 602 can be provided for a physical CDU 604 to model a behavior and operation of aspects of the physical CDU 604. As discussed above, models can be provided for all or a portion (e.g., the heat exchanger model 502 illustrated in FIG. 5) of a CDU. Further, models can be provided for cooling systems that include multiple cooling units (e.g., multiple CDUs, RPUs, rear-door cooling units, air-to-liquid cooling units, chillers, etc.). In the illustrated example, the models include a stress model 602a, a vibration model 602b, a thermal model 602c, a data-driven model 602d, and a reliability model 602e. In some cases, additional models can be provided to model additional system characteristics. For example, models for a cooling unit can include a power consumption model, a vibration model, a computational fluid dynamics model, a finite element analysis model, etc. In the illustrated example, models of the plurality of models 602 can be defined based on physical characteristics of the system. For example, the vibration model 602a can be primarily or entirely based on physical characteristics of the CDU 604 defined in a three-dimensional CAD model of the CDU 604. Further, the stress model 602a can be based on defined geometries and properties of materials of the CDU 604 as defined in the CAD model. The thermal model 602c can be physics-based, and can predict a thermal performance of the system based on known characteristics of the flow path through the CDU 604, materials of components of the CDU 604, efficiencies of components of the CDU 604, etc. In some cases, models can be developed based on artificial intelligence techniques and methods. For example, the data driven model 602d can identify features in data from CDU operation that can correlate to predicted outcomes. In some cases, a data-driven model can identify correlations between inputs and predicted behaviors or outcomes that are not derivable from physics-based model alone. In some cases, data-driven models of a digital twin can utilize supervised learning techniques to predict outcomes based on label inputs. In some cases, data-driven models can utilize unsupervised learning techniques to identify patterns in unlabeled data.

Some or all of the models 602 can comprise physics-based models and artificial intelligence models. For example, models can be based on predefined system characteristics (e.g., materials, geometries, flow arrangements, etc.), but predictions based on those models can differ from a system behavior. A fluid outlet temperature (e.g., fluid outlet temperature measured at sensor module 208e shown in FIG. 2) can differ from a predicted outlet temperature of the thermal model 602c. The thermal model 602c can be tuned based on historic or real-time data from the data store 606 to provide a more accurate prediction of system behavior. In some cases, fine-tuning a physics-based model can include adding one or more convolutional layers downstream of an output of the physics-based model, and transforming the output at the convolutional layers to achieve an adjusted result.

The models 602 can be incorporated into a model 608 (e.g., a digital twin) of a CDU (or other cooling infrastructure) and can be used to simulate a behavior of the CDU 604 under specified conditions. The model 608 can be engageable by an operator or other systems via an interface, as described above, and can generate outputs, alerts, recommendation, command signals, predictions etc. based on an input. For example, the model 608 can receive as an input (e.g., via an API, a CLI, a web interface, etc.) input values 610 for operating parameters of a CDU (e.g., operational parameters obtained from the CDU 604 or simulated operating parameters input by an operator or other system). Input values can include a power input, a fan speed, a pump speed (e.g., in revolutions per minute (RPMs)), valve positions for flow control valves, operating modes for pumps (e.g., active-active, active-passive, primary-secondary, etc.) or other configurable inputs for the CDU. Further, inputs at 610 can include a selection of a target parameter for PID controllers (e.g., one of an outlet temperature, a differential temperature, an outlet pressure, a flow rate of fluid through the CDU, etc.), configurable gains for the PID controllers, etc. In some cases, an operator can provide inputs 610 to the model 608 to perform scenario planning for different possible scenarios within a data center. In some cases, the inputs 610 can be obtained directly from the CDU 604 in real-time, near real-time, or as historical data to be analyzed.

The model 608 can receive the inputs 610, and generate outputs (e.g., predicted system parameters, failure conditions, optimized configurations, etc.) based on the inputs 610. In some cases, outputs can comprise predefined or preselected outputs. For example, outputs of the digital twin can be an outlet temperature of a fluid coolant given the inputs 610. In some cases, outputs can include predicted failures of components, optimal configuration values given the inputs 610, a servicing recommendation, etc. In some cases, a digital twin can perform optimization based on physics-based models, data driven models, and input values. As further shown in FIG. 6, the model 608 can be configured to perform an optimization 612 or solve for particular constraints given inputs 610 and operational data of the CDU 604. An optimization target (e.g., a target value for a parameter, a maximization or minimization of a parameter subject to constraints, etc.) can be provided to be optimized or calculated in the optimization 612. In some cases, the digital twin can be configured to optimize any of an approach temperature for a heat exchanger (e.g., the LTA HX 201 shown in FIG. 2), a supply temperature (e.g., a temperature at a fluid outlet of the CDU 604), a flow rate, a power usage efficiency, etc. As noted above, the model 608 can be provided in a format that can be deployed to a location to provide real-time or near real-time integration with a physical system that the model 608 is being used with (e.g., the systems generating the inputs 610). The model 118 shown in FIG. 1 can be an instance of the model 608, for example.

In some cases, an optimization strategy can be generated from an optimization performed by a digital twin. For example, as shown, optimization strategy 616 is generated from the optimization 612 shown in FIG. 6. An optimization strategy can include recommended values for a configuration of the CDU to achieve the optimal values for the parameters calculated in the optimization 612. In some cases, an optimization strategy can include optimized PID control values to achieve the desired result. In some cases, an optimization strategy can include an operating mode for pumps, fans, or other controllable elements (e.g., valves, refill pumps, etc.). An optimization strategy can include a recommendation to replace or service a component of the CDU 604 (e.g., a recommendation to replace a filter, to service a fan, to replace a pump, etc.).

The optimization strategy 616 can be used to control an operation of the CDU 604. In some cases, the optimization strategy can be provided to an operator (e.g., the optimization strategy can be received at computing system 110 shown in FIG. 1 for use by an operator in controlling an operation of the CDU 102). In some cases, the optimization strategy can be implemented directly, and a command signal or communication can be provided to the physical CDU 604 based on the optimization 612 to control a configuration of the CDU 604, an operation of pumps and fans, etc. In some cases, an optimization strategy 616 can define configurations to be changed for the physical CDU 604, and these values can be provided to an operator (e.g., at the compute 108) for approval by the operator. When the operator approves, a signal can be provided to the physical CDU 604 (e.g., to the CDU 102 from the computing system 116) to implement the optimization strategy.

In some cases, the model 608 can be continually trained on operational data from the CDU 604. As shown, the CDU 604 can provide a stream of data to the model 608 to update the digital twin. In some cases, the data can be used in artificial intelligence algorithms to adjust one or more of the models 602. For example, if a predicted value of an operational parameter differs from an actual value of the parameter under the same conditions by a threshold about, artificial intelligence models can be trained on the operational data to better fit predicted behavior of the CDU 604 to an actual behavior of the CDU 604. In some cases, the CDU 604 can provide operational data to the model 608 for training when an actual performance of the CDU 604 differs from a performance predicted by the digital twin (e.g., a predicted operational parameter is outside a range or a margin of error from the actual operational parameter).

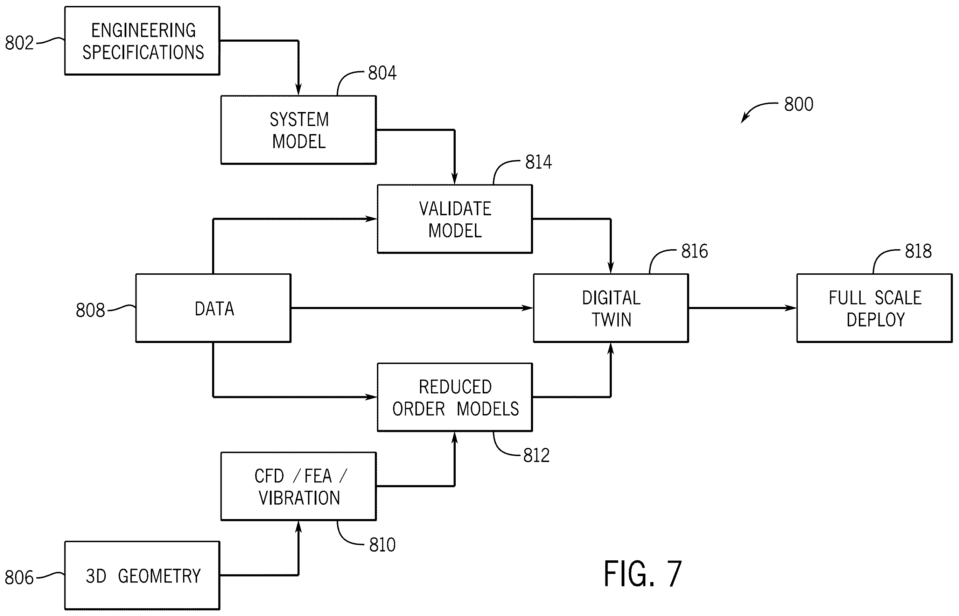

FIG. 7 illustrates a process 800 for developing and deploying a model for cooling infrastructure (e.g., a digital twin of cooling unit 102 shown in FIG.1 ), according to some aspects of the disclosure. At block 802, engineering specifications can be received or developed. Engineering specifications can include a required cooling capacity for cooling infrastructure (e.g., a CDU) to provide cooling to a set of electrical equipment (e.g., electrical equipment housed in racks of a data center). Specifications can include a required flow rate of fluid through a cooling unit, a space constraint of the cooling unit, a minimum approach temperature for a heat exchanger, etc.

At block 804, a system model can be developed. In some cases, a system architecture can be developed to determine components of the cooling unit. For example, system components can be selected based on the engineering specifications at block one and constraints for the system. Preparing a system model at block 804 can include selecting any of particular pumps, fans, heat exchangers, filters, controllers, valves, and other components of the system. In some cases, an arrangement of a heat exchanger (e.g., an orientation of the heat exchanger within a volume) can be determined as part of the system model at block 804. A plumbing arrangement can further be developed as part of the system model, including a relative positioning of components along a fluid flow path, the existence and positioning of bypass lines, etc. In some cases, the system model can be a combination of models for individual cooling units that can be combined in a cooling system. For example, in some cases, an in-row LTA CDU can be used along a primary cooling loop that includes other cooling units (e.g., other in-row LTA CDUs, in-rack LTA CDUs, LTL CDUs, rear-door cooling units, chillers, etc.). A system model can be a combination of individual system models for the cooling units that can be used to model attributes of the system as a whole, in addition to attributes and performance characteristics of the individual cooling units.

A system model can provide a physics-based model, and can be tested and revised based on known historical data. For example, historic performance data can be used to validate a system model. At block 814, the system model can be validated using testing data. Testing data can be data obtained in a testing of the unit corresponding to the system model. In some cases, the data can be data from a similar unit that can be used to validate aspect of the performance or behavior of the system model. In some cases, testing data can comprise data obtained from individual components (e.g., pumps, fans, heat exchangers, etc.). Validating the system model can comprise comparing an output from the system model (e.g., given particular inputs and environmental conditions) and a value from the historical data. For example, with reference to FIG. 5, a system model can include a model for a heat exchanger, and validating the system model can include comparing an outlet air temperature (pT) of the system model to an outlet air temperature from the historical data under the same or similar conditions (e.g., given the same inputs). In some cases, if an output of the system model differs from the historical data by a threshold amount (e.g., is outside of a margin of error), the system model can be revised. In some cases, revising a system model can include performing a training operation (e.g., an artificial intelligence training operation) for the system model. In an example, training the system model can include adding one or more convolutional layers to the system model (e.g., upstream or downstream of the physics-based model) to transform an output to provide more accurate predictions of a system behavior (e.g., an output that is closer to the outputs of the historical data at block 808).

In some cases, additional models can be developed for a cooling unit or cooling infrastructure of a data center. For example, a three-dimensional geometry for the cooling unit (e.g., the CDU 102 shown in FIG. 1) can be developed at block 806. The three-dimensional geometry can be defined in a CAD file including three-dimensional renderings of the cooling unit and components of the cooling unit. In some cases, the CAD file can include material properties of components, information about physical interfaces (e.g., fasteners, welded connections, hinged arrangements, quick-connect fittings, movable handles for valves, etc.). The 3D model can be used at block 810 to develop models for a physical performance of the cooling unit. For example, at block 810, computational flow dynamics (CFD), finite element analysis (FEA), and vibration models can be developed based on the 3D geometry of the cooling unit (e.g., as defined in the CAD file).

In some cases, a complexity of models (e.g., physics-based models and artificial intelligence models) can consume a large amount of computational resources and in some cases, can require hours or days to perform simulations. At block 812, reduced order models can be provided for the CFD, FEA, and vibration models. In some cases, a reduced order model can include a linearization of complex model. In some cases, reduced order models can be developed for any of the models discussed herein. Reduced order models can be trained and validated on the historical data from block 808. Training a reduced order model can include testing a significance of inputs (e.g., features) in producing an output, and pruning inputs that increase a computational complexity of the model without producing an increased accuracy for the model. In some cases, reduced order models can be tested and refined using a training data set of the data from block 808, and can be validated on a validation data set of the data from block 808.

At block 816, the models (e.g., the validated system model of block 804, and the reduced order models of block 812) can be incorporated into a digital twin (e.g., any of models 104, 608 shown in FIGS. 1 and 6). Incorporating the models into a digital twin can include preparing a software package including the models in a unified application. In some cases, the digital twin can comprise one or more software modules (e.g., packages, containers, libraries, collections of files, etc.). The software modules can be installable onto a computer system (e.g., computer system 106 shown in FIG. 1, and can provide an application engageable by an operator or other computer systems (e.g., via an API, a web interface, a CLI, etc.).

At block 818, the digital twin can be deployed for use in production environments. Deploying a digital twin can include installing the software modules of the digital twin onto one or more computing systems (e.g., computer system 106 shown in FIG. 1) that are accessible (e.g., via a networked or wired connection) to an operator (e.g., via computer system 110 shown in FIG. 1) or cooling units (e.g., cooling unit 102 shown in FIG. 1) corresponding to the digital model. Deploying the model at block 818 can include deploying the model to an edge location, where the model can be collocated with the physical infrastructure being modeled (e.g., the model 118 can be installed on the computing system 116 shown in FIG. 1).

Artificial intelligence models referenced herein may be gradient boosting models, random forest models, neural networks (NN), regression models, logistic regression models, decision tree models, Naive Bayes models, or machine learning algorithms (MLA). An MLA or a NN may be trained from a training data set. MLAs include supervised algorithms (such as algorithms where the features/classifications in the data set are annotated or "labeled") using linear regression, logistic regression, decision trees, classification and regression trees, Naive Bayes, nearest neighbor clustering; unsupervised algorithms (such as algorithms where no features/classification in the data set are annotated) using Apriori, means clustering, principal component analysis, random forest, adaptive boosting; and semi-supervised algorithms (such as algorithms where an incomplete number of features/classifications in the data set are annotated) using generative approach (such as a mixture of Gaussian distributions, mixture of multinomial distributions, hidden Markov models), low density separation, graph-based approaches (such as mincut, harmonic function, manifold regularization), heuristic approaches, or support vector machines. NNs include conditional random fields, convolutional neural networks, attention based neural networks, deep learning, long short term memory networks, or other neural models. While MLA and neural networks identify distinct approaches to machine learning, the terms may be used interchangeably herein. Thus, a mention of MLA may include a corresponding NN or a mention of NN may include a corresponding MLA unless explicitly stated otherwise. Some MLA may identify features of importance and identify a coefficient, or weight, to them. The coefficient may be multiplied with the occurrence frequency of the feature to generate a score, and once the scores of one or more features exceed a threshold, certain classifications may be predicted by the MLA. A coefficient schema may be combined with a rule based schema to generate more complicated predictions, such as predictions based upon multiple features. For example, ten key features may be identified across different classifications. A list of coefficients may exist for the key features, and a rule set may exist for the classification. A rule set may be based upon the number of occurrences of the feature, the scaled weights of the features, or other qualitative and quantitative assessments of features encoded in logic known to those of ordinary skill in the art. In other MLA, features may be organized in a binary tree structure. For example, key features which distinguish between the most classifications may exist as the root of the binary tree and each subsequent branch in the tree until a classification may be awarded based upon reaching a terminal node of the tree. For example, a binary tree may have a root node which tests for a first feature. The occurrence or non-occurrence of this feature must exist (the binary decision), and the logic may traverse the branch which is true for the item being classified. Additional rules may be based upon thresholds, ranges, or other qualitative and quantitative tests.

### FURTHER EXAMPLES

Example 1. A computer implemented method, comprising: receiving, at a computing system, a first real-time input from a cooling system, the cooling system comprising a physical cooling unit to provide cooling to a liquid coolant, the physical cooling unit located within a first range of the computing system; providing the first real-time input to a machine learning model stored within a memory of the computing system, the machine learning model including a model of the physical cooling unit, and trained to predict a behavior of the physical cooling unit; generating, by the machine learning model, a first output comprising a predicted value of an operational parameter, the first output being based at least in part on the first real-time input; generating an instruction for an operation of the physical cooling unit based on the first output; and communicating the instruction to a controller of the physical cooling unit.

Example 2. The method of Example 1, wherein the physical cooling unit is one of a liquid-to-air coolant distribution unit (CDU), a liquid-to-liquid CDU, an air-to-liquid cooling unit, a rear-door cooling unit, and an in-rack CDU.

Example 3. The method of Example 1 or Example 2, further comprising receiving, from the cooling system, a real-time stream of operational data, the real-time stream including the first real-time input.

Example 4. The method of any one of Examples 1 to 3, wherein the instruction comprises a command to change a configuration of the cooling system.

Example 5. The method of any one of Examples 1 to 4, wherein the machine learning model includes a plurality of models.

Example 6. The method of Example 5, wherein the plurality of models includes one or more of a vibration model, a computational fluid dynamics model, and a finite element analysis model.

Example 7. The method of any one of Examples 1 to 6, wherein the computing system and the physical cooling unit communicate using an internet of things (IoT) communication protocol.

Example 8. The method of any one of Examples 1 to 7, wherein the machine learning model is configured to optimize a target parameter of the physical cooling unit based on the first real-time input.

Example 9. The method of Example 8, wherein the target parameter is one of an approach temperature, an inlet temperature, a flow rate, and a power usage efficiency.

Example 10. The method of any one of Examples 1 to 9, wherein the first range is a distance allowing for a network latency between the computing system and the physical cooling unit of less than 1 millisecond.

Example 11. The method of Example 10, wherein the computing system and the physical cooling unit are located within the same data center.

Example 12. An edge computing system for a coolant distribution unit, the system comprising: a coolant distribution unit to provide cooling to a liquid coolant; a computing system located within a first range of coolant distribution unit; and a machine learning model stored within a memory of the computing system, the machine learning model including a model of the coolant distribution unit, and the machine learning module being trained to predict a behavior of the coolant distribution unit, wherein the computing system is configured to: receive a first real-time input from the coolant distribution unit, provide the first real-time input to the machine learning model, generate, by the machine learning model, a first output comprising a predicted value of an operational parameter based at least in part on the first real-time input, generate an instruction for an operation of the coolant distribution unit based on the first output, and communicate the instruction to a controller of the coolant distribution unit.

Example 13. The system of Example 12, wherein the coolant distribution unit is one of a liquid-to-air coolant distribution unit (CDU), a liquid-to-liquid CDU, an air-to-liquid cooling unit, a rear-door cooling unit, and an in-rack CDU.

Example 14. The system of Example 12 or Example 13, wherein the machine learning model includes a plurality of models comprising one or more of a vibration model, a computational fluid dynamics model, and a finite element analysis model.

Example 15. The system of Example 14, wherein the machine learning model is configured to optimize a target parameter of the coolant distribution unit based on the first real-time input.

Example 16. The system of Example 15, wherein the target parameter is one of an approach temperature, an inlet temperature, a flow rate, and a power usage efficiency.

Example 17. A non-transitory computer-readable medium storing instructions that, when executed by a processor of a computing system, cause the computing system to: receive a first real-time input from a cooling system, the cooling system comprising a physical cooling unit to provide cooling to a liquid coolant, the physical cooling unit located within a first range of the computing system; provide the first real-time input to a machine learning model stored within a memory of the computing system, the machine learning model including a model of the physical cooling unit and trained to predict a behavior of the physical cooling unit; generate, by the machine learning model, a first output comprising a predicted value of an operational parameter based at least in part on the first real-time input; generate an instruction for an operation of the physical cooling unit based on the first output; and communicate the instruction to a controller of the physical cooling unit.

Example 18. The non-transitory computer-readable medium of Example 17, wherein the coolant distribution unit is one of a liquid-to-air coolant distribution unit (CDU), a liquid-to-liquid CDU, an air-to-liquid cooling unit, a rear-door cooling unit, and an in-rack CDU.

Example 19. The non-transitory computer-readable medium of Example 17 or Example 18, wherein the machine learning model includes a plurality of models comprising one or more of a vibration model, a computational fluid dynamics model, and a finite element analysis model.

Example 20. The non-transitory computer-readable medium of Example 19, wherein the machine learning model is configured to optimize a target parameter of the coolant distribution unit based on the first real-time input, and wherein the target parameter is one of an approach temperature, an inlet temperature, a flow rate, and a power usage efficiency.

It is to be understood that the invention is not limited in its application to the details of construction and the arrangement of components set forth in the description or illustrated in the drawings. The invention is capable of other embodiments and of being practiced or of being carried out in various ways. Also, it is to be understood that the phraseology and terminology used herein is for the purpose of description and should not be regarded as limiting. The use of "including," "comprising," or "having" and variations thereof herein is meant to encompass the items listed thereafter and equivalents thereof as well as additional items. Unless specified or limited otherwise, the terms "mounted," "connected," "supported," and "coupled" and variations thereof are used broadly and encompass both direct and indirect mountings, connections, supports, and couplings. Further, "connected" and "coupled" are not restricted to physical or mechanical connections or couplings.

Similarly, unless otherwise limited or defined, "or" indicates a non-exclusive list of components or operations that can be present in any variety of combinations, rather than an exclusive list of components that can be present only as alternatives to each other. For example, a list of "A, B, or C" indicates options of: A; B; C; A and B; A and C; B and C; and A, B, and C. Correspondingly, the term "or" as used herein is intended to indicate exclusive alternatives only when preceded by terms of exclusivity, such as "only one of," or "exactly one of." For example, a list of "only one of A, B, or C" indicates options of: A, but not B and C; B, but not A and C; and C, but not A and B. In contrast, a list preceded by "one or more" (and variations thereon) and including "or" to separate listed elements indicates options of one or more of any or all of the listed elements. For example, the phrases "one or more of A, B, or C" and "at least one of A, B, or C" indicate options of: one or more A; one or more B; one or more C; one or more A and one or more B; one or more B and one or more C; one or more A and one or more C; and one or more A, one or more B, and one or more C. Similarly, a list preceded by "a plurality of" (and variations thereon) and including "or" to separate listed elements indicates options of one or more of each of multiple of the listed elements. For example, the phrases "a plurality of A, B, or C" and "two or more of A, B, or C" indicate options of: one or more A and one or more B; one or more B and one or more C; one or more A and one or more C; and one or more A, one or more B, and one or more C.

Also as used herein, unless otherwise limited or defined, the terms "about" and "approximately" refer to a range of values ± 5% of the numeric value that the term precedes. As a default the terms "about" and "approximately" are inclusive to the endpoints of the relevant range, but disclosure of ranges exclusive to the endpoints is also intended.

Also as used herein, unless otherwise limited or defined, "integral" and derivatives thereof (e.g., "integrally") describe elements that are manufacture as a single piece without fasteners, adhesive, or the like to secure separate components together. For example, an element stamped as a single-piece component from a single piece of sheet metal, without rivets, screws, or adhesive to hold separately formed pieces together is an integral (and integrally formed) element. In contrast, an element formed from multiple pieces that are separately formed initially then later connected together, is not an integral (or integrally formed) element.

Also as used herein, unless otherwise defined or limited, the term "lateral" refers to a direction that does not extend in parallel with a reference direction. A feature that extends in a lateral direction relative to a reference direction thus extends in a direction, at least a component of which is not parallel to the reference direction. In some cases, a lateral direction can be a radial or other perpendicular direction relative to a reference direction.

Also as used herein, unless otherwise defined or limited, the term "substantially identical" indicates components or features that are manufactured to the same specifications (e.g., as may specify materials, nominal dimensions, permitted tolerances, etc.), using the same manufacturing techniques. For example, multiple parts stamped from the same material, to the same tolerances, using the same mold may be considered to be substantially identical, even though the precise dimensions of each of the parts may vary from the others.

Features which are described in the context of separate embodiments may also be provided in combination in a single embodiment. Features which are, for brevity, described in the context of a single embodiment, may also be provided separately or in any suitable sub-combination, or combined as new embodiments. The applicant hereby gives notice that new claims may be formulated to one or more features and/or combinations of such features during the prosecution of the present application or of any further application derived therefrom. Feature(s) of the edge computing system or computer readable medium described may be incorporated into/used in corresponding methods and vice versa.

The previous description of the disclosed embodiments is provided to enable any person skilled in the art to make or use the invention. Various modifications to these embodiments will be readily apparent to those skilled in the art, and the generic principles defined herein may be applied to other embodiments without departing from the spirit or scope of the invention. Thus, the invention is not intended to be limited to the embodiments shown herein but is to be accorded the widest scope consistent with the principles and novel features disclosed herein.

## Claims

1. A computer implemented method, comprising:
receiving, at a computing system, a first real-time input from a cooling system, the cooling system comprising a physical cooling unit to provide cooling to a liquid coolant, the physical cooling unit located within a first range of the computing system;
providing the first real-time input to a machine learning model stored within a memory of the computing system, the machine learning model including a model of the physical cooling unit, and trained to predict a behavior of the physical cooling unit;
generating, by the machine learning model, a first output comprising a predicted value of an operational parameter, the first output being based at least in part on the first real-time input;
generating an instruction for an operation of the physical cooling unit based on the first output; and
communicating the instruction to a controller of the physical cooling unit.

2. The method of claim 1, wherein the physical cooling unit is one of a liquid-to-air coolant distribution unit (CDU), a liquid-to-liquid CDU, an air-to-liquid cooling unit, a rear-door cooling unit, and an in-rack CDU.

3. The method of claim 1, further comprising receiving, from the cooling system, a real-time stream of operational data, the real-time stream including the first real-time input.

4. The method of claim 1, wherein the instruction comprises a command to change a configuration of the cooling system.

5. The method of claim 1, wherein the machine learning model includes a plurality of models; and, optionally,
wherein the plurality of models includes one or more of a vibration model, a computational fluid dynamics model, and a finite element analysis model.

6. The method of claim 1, wherein the computing system and the physical cooling unit communicate using an internet of things (IoT) communication protocol.

7. The method of claim 1, wherein the machine learning model is configured to optimize a target parameter of the physical cooling unit based on the first real-time input; and, optionally,
wherein the target parameter is one of an approach temperature, an inlet temperature, a flow rate, and a power usage efficiency.

8. The method of claim 1, wherein the first range is a distance allowing for a network latency between the computing system and the physical cooling unit of less than 1 millisecond; and, optionally,
wherein the computing system and the physical cooling unit are located within the same data center.

9. An edge computing system for a coolant distribution unit, the system comprising:
a coolant distribution unit to provide cooling to a liquid coolant;
a computing system located within a first range of coolant distribution unit; and
a machine learning model stored within a memory of the computing system, the machine learning model including a model of the coolant distribution unit, and the machine learning module being trained to predict a behavior of the coolant distribution unit, wherein the computing system is configured to:
receive a first real-time input from the coolant distribution unit,
provide the first real-time input to the machine learning model,
generate, by the machine learning model, a first output comprising a predicted value of an operational parameter based at least in part on the first real-time input,
generate an instruction for an operation of the coolant distribution unit based on the first output, and
communicate the instruction to a controller of the coolant distribution unit.

10. The system of claim 9, wherein the coolant distribution unit is one of a liquid-to-air coolant distribution unit (CDU), a liquid-to-liquid CDU, an air-to-liquid cooling unit, a rear-door cooling unit, and an in-rack CDU.

11. The system of claim 9, wherein the machine learning model includes a plurality of models comprising one or more of a vibration model, a computational fluid dynamics model, and a finite element analysis model; and, optionally,
wherein the machine learning model is configured to optimize a target parameter of the coolant distribution unit based on the first real-time input; and, optionally,
wherein the target parameter is one of an approach temperature, an inlet temperature, a flow rate, and a power usage efficiency.

12. A non-transitory computer-readable medium storing instructions that, when executed by a processor of a computing system, cause the computing system to:
receive a first real-time input from a cooling system, the cooling system comprising a physical cooling unit to provide cooling to a liquid coolant, the physical cooling unit located within a first range of the computing system;
provide the first real-time input to a machine learning model stored within a memory of the computing system, the machine learning model including a model of the physical cooling unit and trained to predict a behavior of the physical cooling unit;
generate, by the machine learning model, a first output comprising a predicted value of an operational parameter based at least in part on the first real-time input;
generate an instruction for an operation of the physical cooling unit based on the first output; and
communicate the instruction to a controller of the physical cooling unit.

13. The non-transitory computer-readable medium of claim 12, wherein the coolant distribution unit is one of a liquid-to-air coolant distribution unit (CDU), a liquid-to-liquid CDU, an air-to-liquid cooling unit, a rear-door cooling unit, and an in-rack CDU.

14. The non-transitory computer-readable medium of claim 13, wherein the machine learning model includes a plurality of models comprising one or more of a vibration model, a computational fluid dynamics model, and a finite element analysis model.

15. The non-transitory computer-readable medium of claim 14, wherein the machine learning model is configured to optimize a target parameter of the coolant distribution unit based on the first real-time input, and wherein the target parameter is one of an approach temperature, an inlet temperature, a flow rate, and a power usage efficiency.
